(19) Europäisches Patentamt
European Patent Office
Office européen des brevets

(11) **EP 1 753 129 B1**

(12) **EUROPEAN PATENT SPECIFICATION**

(45) Date of publication and mention
of the grant of the patent:
**20.07.2011   Bulletin 2011/29**

(51) Int Cl.:
***H03F 3/45*** *(2006.01)*

(21) Application number: **05017344.2**

(22) Date of filing: **10.08.2005**

(54) **Receiver with high input range**

Empfänger mit grossem Eingangsbereich

Récepteur avec intervalle d'entrée étendu

(84) Designated Contracting States:
**DE FR GB IT**

(43) Date of publication of application:
**14.02.2007   Bulletin 2007/07**

(73) Proprietor: **Semiconductor Components Industries, LLC**
**Phoenix, AZ 85008 (US)**

(72) Inventor: **Sekerkiran, Barbaros**
**Etiler Istanbul (TR)**

(74) Representative: **Bird, Ariane et al**
**Bird Goën & Co**
**Klein Dalenstraat 42A**
**3020 Winksele (BE)**

(56) References cited:
**EP-A- 0 486 071         EP-A- 1 445 902**
**EP-A2- 1 286 143       US-A1- 2002 163 381**
**US-B1- 6 654 462**

**Description**

**Field of the invention:** This invention relates to methods and apparatus, including circuits for receivers, e.g. telecommunications receivers and to integrated circuits having such receivers, especially pre-amplifiers for receivers.

**Description of the Related Art:**

The declining cost of silicon for a given functionality makes the contribution of packaging to total system cost more pronounced. Increasing the bit transfer rate per pin leads to lower pin-count packages, less complicated PCB's. For high speed signaling applications, it is advantageous to limit the amplitude to satisfy EMC restrictions and to decrease the power consumption. To satisfy these demands, Low Voltage Differential Signaling, LVDS, was proposed as a low cost and low power alternative to other high speed interface standards such as ECL and CML. The LVDS standard [IEEE Standard for Low-Voltage Differential Signals (LVDS) for Scalable Coherent Interface (SCI), 1596.3 SCI-LVDS Standard, IEEE Std 1596.3-1996, 1994] combines a lower differential swing with a very high ground noise immunity requirement which makes the design of the LVDS receiver a challenging issue. The receiver is expected to sense a differential voltage around 300mV superposed on a common-mode noise with an amplitude reaching 1V. Moreover, frequency spectrum of the common-mode signal extends from DC to 1GHz causing important perturbation on any input stage biasing condition. If propagation delay of the receiver is sensitive to this perturbation, the common-mode signal is translated to jitter and causes closing of eye opening at the receiver output. Another challenge is keeping the variation on hysteresis voltage small, not only over temperature and process corners, but also throughout input voltage range. Here a tradeoff appears between simple and complicated input structures. High speed and low power requirements lead to simpler structures, while keeping biasing conditions stable necessitates complicated compensation circuitry. Deep submicron CMOS technologies add another difficulty to this challenge. In 0.18μm technology the supply voltage scales down to 1.8V making it impossible to reach an input range of 2.4V using conventional input circuits. Thick oxide transistors are usually available in deep submicron technologies to provide 3.3V standard IO interface. Although they seem to be an alternative to overcome the low supply voltage problem, they are significantly slower compared to their thin oxide counterparts. In addition, they cause higher power consumption on the silicon due to their higher supply voltage.

Receiver Design

Differential pairs are adopted in a majority of high-speed interface receivers, as an input stage. In many known differential receivers, a comparator is provided in the form of a differential amplifier preceded by an input stage in the form of a very high-speed differential pre-amplifier with low and controlled gain. The pre-amplifier amplifies the differential signal and attenuates the common mode signal. A simple differential pair of either NMOS transistors or PMOS transistors is not able to work over this full input range. Therefore, two input differential pairs are generally put in parallel: a PMOS and a NMOS differential pair. The outputs of these two differential pairs are combined into the inputs of the comparator. Each differential pair spans a part of the input voltage range. In the middle of this voltage range both PMOS and NMOS input pairs are active, whilst for input voltages near to the ground or to the supply voltage, either only the PMOS inputs or only the NMOS inputs are active. As a consequence, the gain of the input pre-amplifier is not constant over the whole input voltage range. Traditional circuits to keep the gain constant are much too slow for complying with the standard requirements and can thus not be used. Moreover, since the output of the known pre-amplifier is related to the ground or to the supply voltage, the design of the subsequent comparator or differential amplifier is more difficult.

In 3.3V supply applications, a single PMOS differential pair can provide sufficient input range to comply with the LVDS standard [see A. Boni, A. Pierazzi and D. Vecchi, "LVDS I/O Interface for Gb/s-per-Pin Operation in 0.35-μm CMOS," IEEE J.Solid-State Circuits, vol. 36, no. 4, pp 706-711, April 2001], while 2.5V supply applications entail a combination of NMOS and PMOS differential pairs to cover the rail to rail input range. Unfortunately, even the rail-to-rail input range capability falls short to cover the LVDS standard requirement when the supply voltage scales down further in deep submicron technologies. Moreover, a large and rapidly changing common-mode signal causes important disturbances in the biasing condition of the differential pairs, mainly due to charging of the parasitic capacitance associated with the common source node.

In U.S. Patent 6 288 576, Sept. 2001, H. J. Casier "Fast Pre-amplifier for an Interface Arrangement", it is proposed to make the gain constant over the relatively large input voltage range for a relatively small input signal, by providing a differential pre-amplifier comprising a first and a second half pre-amplifier, each receiving both differential inputs. The first half pre-amplifier is coupled to the output of the first half pre-amplifier via first input inverter means, and a current mirror is provided for inverting the output current of a second input inverter means with respect to the output current of said first input inverter means.

In this way, opposite currents coming from the first and from the second input inverter means are provided to the output of each half pre-amplifier. Since the two half pre-amplifiers are oppositely connected with respect to each other, a very high common mode signal attenuation is obtained. The inverter means behaves as an amplifier with the full supply voltage as input range. As a result, the large common mode range can be covered. A very high-speed is also possible owing to the low skew between the signals and the signal input range can be as wide as the full supply voltage.

When the common-mode input voltage approaches the upper or lower rail value, the PMOS or NMOS pair enters cut-off, respectively. Constant gm circuits conventionally used in operational amplifiers are too slow to provide an effective compensation in LVDS applications. Response time variations due to changes in biasing conditions cause jitter and result in closing of the eye.

One approach is to use a resistive voltage divider on both inputs [M. Aguirre, C. Heredia, H. Torres, R. Palomera, M. Jiménez, "Design of a CMOS 1.8V Low Voltage Differential Signaling Receiver," in Proc. Of the 45th IEEE Midwest Symposium on Circuits and Systems (MWCAS 2002), Vol. 2, pp 647-649. Aug 2002]. A drawback is that this attenuates the differential signal as well as the common mode signal. This reduction in the differential signal amplitude is undesirable and can reduce performance of subsequent parts of the circuit in various ways.

It is also known to use chokes for suppressing common mode noise components in LVDS signals, but these add to the component count and are not suitable for integration.

Other such art is found in US 6654462, EP 486 071, EP 1286143 and US 2002/163381.

**Summary of the Invention:**

An object of the invention is to provide improved methods or apparatus such as receivers, e.g. telecommunications receivers and to integrated circuits having such receivers, especially pre-amplifiers which can be used in receivers.

The invention provides a common mode suppression circuit, having resistive inputs for receiving a differential signal, and having corrective signal generating circuitry arranged to use a signal from a first of the resistive inputs to generate a corrective signal to suppress a common mode component in the signal from the second of the resistive inputs, whereby the corrective signal generating circuitry comprises a current mirror circuit having two transistors (M1, M2), the first resistive input of the differential signal (V1A) is coupled over a first resistor (R1) with a main power electrode of the first one (M1) of the two transistors and the second resistive input of the differential signal (V1B) is coupled over a second resistor (R2) with a main power electrode of the second transistor (M2), whereby the gate and said main power electrode of the first transistor (M1) are connected with each other and with the gate of the second transistor (M2), and whereby the node (D) between the second resistor (R2) and said main power electrode of the second transistor (M2) constitutes the output of the common mode suppression circuit, **characterized in that** the common mode suppression circuit comprises further a second current mirror circuit, connected in parallel with the first one, the transistors (M3, M4) in the second current mirror circuit being of the complementary type of the transistors (M1, M2) in the first current mirror circuit and wherein characteristics of the transistors and the values of the resistors are arranged to provide a corrective signal with an amplitude and a timing adapted to suppress said common mode component.

Other aspects of the invention provide an integrated circuit, and a receiver for receiving differential signals.

Any of the additional features can be combined together and combined with any of the aspects. Other advantages will be apparent to those skilled in the art, especially over other prior art. Numerous variations and modifications can be made without departing from the claims of the present invention. Therefore, it should be clearly understood that the form of the present invention is illustrative only and is not intended to limit the scope of the present invention.

**Brief Description of the Drawings:**

How the present invention may be put into effect will now be described by way of example with reference to the appended drawings, in which:

FIG. 1 shows a receiver in schematic form,
FIG. 2 shows common mode suppression circuitry
FIG. 3 shows common-mode suppression circuitry
FIG. 4 shows an embodiment of a complementary version of common-mode suppression circuitry, and
FIG. 5 shows a simplified schematic of an embodiment of a receiver.

**Description of the Preferred Embodiments:**

The present invention will be described with respect to particular embodiments and with reference to certain drawings but the invention is not limited thereto but only by the claims. Any reference signs in the claims shall not be construed as limiting the scope. The drawings described are only schematic and are non-limiting. In the drawings, the size of some of the elements may be exaggerated and not drawn on scale for illustrative purposes. Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

It is furthermore to be noticed that the term "comprising", used in the description and in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

Reference will be made to transistors. These are three-terminal devices: a first main electrode such as a drain, a second main electrode such as a source and a control electrode such as a gate for controlling the follow of electrical charges between the first and second main electrodes.

The present invention is applicable to any electronic production technology, e.g. discrete element circuits, semiconductor processing especially MOS processing and

CMOS processing and is particularly relevant to deep submicron CMOS processing technology. The present invention is particularly applicable when the low voltage supply limits the input voltage range of the device. In the following the present invention will be described with reference to deep submicron CMOS technology only as an example of an implementation method suitable for the present invention.

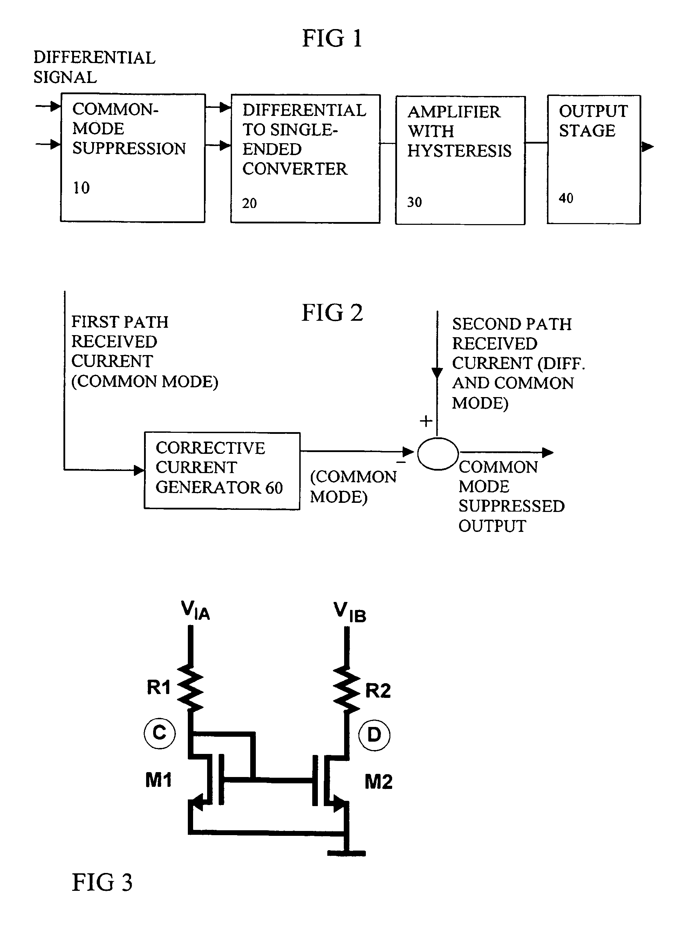

In the embodiments described, a new circuit suitable for a receiver device such as an LVDS receiver implementation in deep submicron CMOS technologies is presented. It can exploit high-speed merits of submicron devices in a low supply voltage application, to achieve high bit transfer rate at low power consumption. The resistive input stage allows an input range exceeding the supply voltage level without danger to sensitive electronic components, e.g. without harming oxide reliability constraints of thin oxide transistors. In figure 1, a schematic view of some of the elements of a receiver are shown. A common mode suppression part 10 receives a differential input signal. This part outputs a differential signal with common mode components partly or completely suppressed, to a converter 20 for converting differential to single ended form. An amplifier 30 with hysteresis is provided optionally.

If the differential signal is a digital signal for example, the amplifier with hysteresis can prevent unwanted oscillatory switching at the time of crossover between digital levels. This function can be combined with part 20 if desired into a single circuitry. An output stage 40 is provided if buffering is needed. Figure 2 shows a schematic view of the common mode suppression part 10. The differential signal is received on first and second input paths, which are resistive. A corrective current generator 60 is coupled to the first input path and outputs a corrective signal reflecting a common mode component. This is subtracted from the current received on the second input path, and the result is an output which has a common mode component suppressed. This can be a single ended signal, or maintained as a differential signal if a similar subtraction is carried out on the first path as well. Other ways of using the corrective signal can be envisaged, though a straightforward combination such as a subtraction helps keep component count and therefore power consumption and costs lower.

The circuit illustrated in Fig. 3 shows one way of implementing the common mode suppression circuit to suppress the common-mode noise. It uses a current mirror comprising transistors M1 and M2 in conjunction with input resistors R1, R2 to preserve the differential signal while attenuating the common-mode signal considerably. Transistors M1 and M2 maybe, for example CMOS, MOSFET, BIPOLAR. The transistors are used as amplifiers.

The control electrodes, e.g. gates of M1 and M2 are coupled together, and are coupled to first of the main power electrodes, e.g. to the drain of M1 at node "C". The second main power electrodes, e.g. sources of M1 and M2 are coupled to a supply rail such as GND. An output is taken from point "D" at the first main electrode, e.g. drain of transistor M2.

The operation of the circuit will now be described. Suppose that both input voltages, $V_{IA}$ and $V_{IB}$, make an upward swing together by $dV$. Assuming that $R_1 = \lambda R_2 = \dfrac{\alpha}{gm_1}$ the gate overdrive voltage of M1 goes up by $\dfrac{dV}{1+\alpha}$,

causing an increase in drain current of M2 by, $\dfrac{\gamma}{1+\alpha} gm_1 \, dV$ where the ratio $\dfrac{gm_2}{gm_1}$ is expressed by $\gamma$ and $\lambda = R_1/R_2$.

Voltage drop across $R_2$ increases by $\dfrac{R_2 \, gm_1 \, \gamma}{1+\alpha} dV$. Since $R_2 = \dfrac{\alpha}{\lambda \, gm_1}$, the voltage drop simplifies to

$\dfrac{\gamma}{\lambda} \dfrac{\alpha}{1+\alpha} dV$. The factor $\dfrac{\gamma}{\lambda} \dfrac{\alpha}{1+\alpha}$ needs to be equal to unity if it is desired to keep the voltage increase across $R_2$ equal

to dV. This means the upward swing of Vib is compensated by the same amount and voltage at node D stays unchanged, to achieve complete suppression. The equation

$$f(\gamma,\lambda,\alpha) = \frac{\gamma}{\lambda}\frac{\alpha}{1+\alpha} = 1 \qquad (1)$$

gives the common-mode rejection criteria in terms of design variables $\gamma,\lambda$ and $\alpha$. The first two variables are determined by geometry of the devices and stay constant even with changing biasing conditions but $\alpha$ depends on gml, and changes with the drain current of M1, therefore with common-mode signal level. Although the circuit is designed to satisfy (1) for nominal value of the common-mode voltage (1.2 V), it is inevitable that the left hand side of the formula deviates from 1 as the common-mode voltage changes. The higher this deviation, the lower the common-mode rejection of the circuit. Hence it is useful to find the optimum values for design variables minimizing this deviation. The dependence of $f(\gamma,\lambda,\alpha)$ on common-mode voltage can be formulised using the chain rule as,

$$\partial\frac{f(\gamma,\lambda,\alpha)}{\partial Vc} = \frac{\partial f(\gamma,\lambda,\alpha)}{\partial\alpha}\ \frac{\partial\alpha}{\partial gm}\ \frac{\partial gm}{\partial Vgs}\ \frac{\partial Vgs}{\partial Id}\ \frac{\partial Id}{\partial Vc} \qquad (2)$$

where Vc is the common-mode voltage $(V_{IA}+V_{IB})/2$. This leads to,

$$\partial\frac{f}{\partial Vc} = \frac{-\gamma(\alpha-1)}{\lambda(\alpha+1)^3}\ R_{IN2}\ \beta\ \frac{1}{\beta(Vgs_{M1}-Vt)}\ \frac{1}{R+\dfrac{1}{gm}} \qquad (3)$$

which simplifies to,

$$\partial\frac{f}{\partial Vc} = -\frac{\gamma}{\lambda}\ \frac{\alpha-1}{(\alpha+1)^4}\ \frac{1}{Vgs_{M1}-Vt} \qquad (4)$$

$f(\gamma,\lambda,\alpha)$ reaches its minimum where its derivative equals to zero. Hence, minimum sensitivity to common-mode voltage changes is obtained for $\alpha=1$.

Referring to Fig 3 again, the corrective current coming from $V_{IA}$ counterbalances the common-mode signal at node $V_{IB}$. Not only the amplitude but also the timing of this correction is important to suppress the common-mode signal more effectively. The signals coming from $V_{IA}$ and $V_{IB}$ should reach the node D at the same time. This requires that the time constants $(R_1 //gm_1)C_C$ and $R_2C_D$ be equal, where $C_C$ and $C_D$ are the total capacitances of nodes C and D, respectively. $C_C$ is the sum of gate capacitances of transistors M1 and M2, and $C_D$ consists mainly of input capacitance of the second stage. Using the definitions, $\lambda=R_1/R_2$ and $\gamma=gm_2/gm_1$, the following is obtained,

$$\frac{R_1 gm_1}{R_1 + gm_1}Cg_{M1}(1+\gamma) = \frac{R_1}{\lambda}C_D \qquad (5)$$

where $Cg_{M1}$ is the gate capacitance of transistor M1. Selecting $\alpha=1$ and substituting this value into (1) leads to $\lambda=\gamma/2$. Arranging the terms in (5) leads to,

$$\gamma \approx 2\sqrt{\frac{C_D}{Cg_{M1}}} - \frac{1}{2} \qquad (6)$$

Having determined $\alpha$ and $\gamma$, the third design parameter $\lambda$ can be calculated using (1). In the analysis of design variables, the secondary effects such as transistor output impedance, device mismatch, etc are ignored for the sake of a simpler formulation.

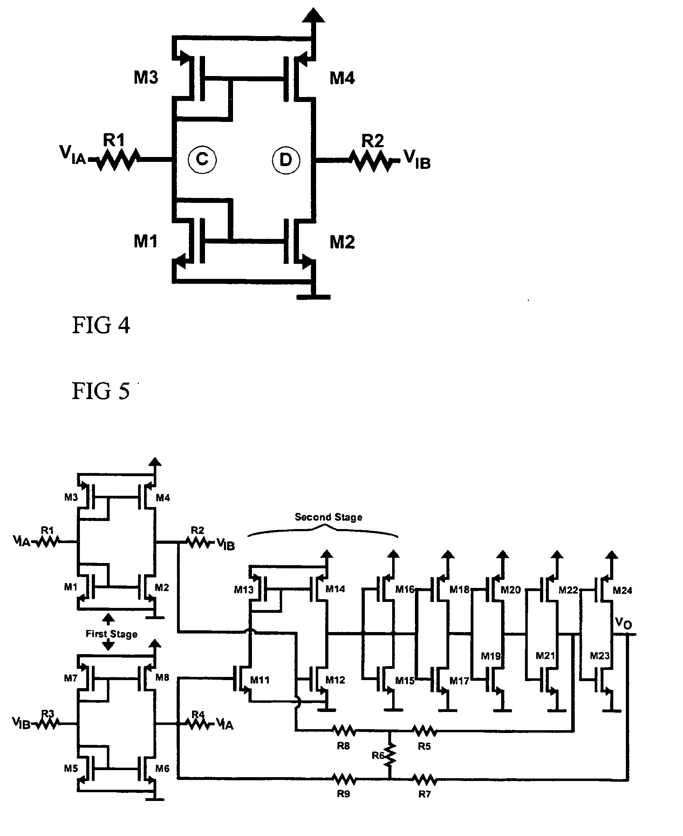

Figure 4 shows the complementary version of the circuit of Figure 3, according to the invention. In addition to the parts shown in Figure 3, each of the input paths has an additional transistor M3, M4 coupled to the other supply line. M3 and M4 are coupled in a similar fashion to M1 and M2. The common-mode voltage swing causes variations on the drain current of M1, while drain current of M3 changes in the reverse direction. The equivalent transconductance, $gm_{EQ}$, is the sum of transconductances of M1 and M3,

$$gm_{EQ} = \beta_{M1}(Vgs_{M1} - Vt_N) + \beta_{M3}(Vgs_{M3} - Vt_P) \tag{7}$$

where $Vt_N$ and $Vt_P$ are threshold voltages of NMOS and PMOS transistors, respectively.
Dimensioning the transistors to equalize their transconductance parameter $\beta$, we obtain,

$$gm_{EQ} = \beta(V_{DD} - Vt_N - Vt_P) \tag{8}$$

The loss in transconductance in one MOS transistor is compensated by an increase in its complementary and a better gm stability over input voltage range is achieved.
Figure 5 shows an example of an application of the circuits of Figs 3 and 4 in a receiver suitable for LVDS or other receivers. The first stage consists of two complementary input circuits as given in Fig 4. These produce a differential output which is fed to a second stage. The differential to single ended conversion is made at the second stage after the common-mode signal is attenuated significantly by the first stage. This second stage has transistors M11, M12, as input transistors, feeding drains of transistors M13 and M14 respectively. This pair has gates coupled together and coupled to the drain of M13. A single ended output is taken from drain of M14. This is fed to diode-connected transistors M15 and M16 to limit the signal amplitude in order to reduce the sensitivity of response time to duty cycle variations. The signal amplified by the second stage is applied to a chain of cascaded inverters using transistors M17 - M24 for pulse shaping and buffering. The hysteresis is implemented using the resistive network R5-R9. The voltage divider R5-R7 reduces the amplitude of the rail-to-rail output signal. The attenuated signal appearing across R7 is applied to the inputs of the second stage through the resistors R8 and R9 to provide a well-controlled positive feedback dependent mainly on a ratio of resistor values.
The circuit can be implemented as an integrated circuit or chip consisting of LVDS receiver and driver pairs in cascade connection, placed on an IO ring. The receiver can be arranged to drive an on-chip LVDS buffer. The signal translated back to LVDS levels can be sent out of the chip for monitoring purposes. This can allow 2.4 Gb/s operation even with noisy input. The receiver draws 4 mA from a 1.8V supply, in typical conditions. The hysteresis voltage is measured as 50mV with $\pm$ 10 mV deviation over full input voltage and temperature range. The input resistors, R1-R4, are selected to be 1.2K$\Omega$, the design parameters $\alpha$ $\gamma$ and $\lambda$ are set to 1, 2 and 1, respectively. The input voltage range can lie between 0V and 3V. The ESD protection circuit is custom designed to have two serially connected diodes allowing an input voltage range exceeding the supply voltage by 1.2V. The inputs have a measured immunity level of 3.5KV for human body model ESD discharges.
An LVDS receiver circuit has been described, combining good common-mode noise immunity with high-speed capability. The architecture of the circuit is suitable for deep submicron CMOS implementations where operation with input signal levels exceeding the supply rail is required.
Owing to a fully resistive implementation of the positive feedback circuitry, the hysteresis voltage achieves a good stability over temperature and common-mode signal, with a measured average level of 50 mV. The circuit consumes 7 mW in typical conditions. The proposed circuit topology takes advantage of high speed merits of deep submicron transistors while overcoming the limit set by their low supply voltage on input voltage range. This makes the circuit even more attractive for future CMOS applications where supply voltage is expected to scale down further.

**Claims**

1. A common mode suppression circuit, having resistive inputs for receiving a differential signal, and having corrective signal generating circuitry arranged to use a signal from a first of the resistive inputs to generate a corrective signal to suppress a common mode component in the signal from the second of the resistive inputs,

whereby the corrective signal generating circuitry comprises a current mirror circuit having two transistors (M1, M2), the first resistive input of the differential signal (V1A) is coupled over a first resistor (R1) with a main power electrode of the first one (M1) of the two transistors and the second resistive input of the differential signal (V1B) is coupled over a second resistor (R2) with a main power electrode of the second transistor (M2),

whereby the gate and said main power electrode of the first transistor (M1) are connected with each other and with the gate of the second transistor (M2), and whereby the node (D) between the second resistor (R2) and said main power electrode of the second transistor (M2) constitutes the output of the common mode suppression circuit,

**characterized in that**

the common mode suppression circuit comprises further a second current mirror circuit, connected in parallel with the first one, the transistors (M3, M4) in the second current mirror circuit being of the complementary type of the transistors (M1, M2) in the first current mirror circuit and

wherein characteristics of the transistors and the values of the resistors are arranged to provide a corrective signal with an amplitude and a timing adapted to suppress said common mode component.

2. The common mode suppression circuit of claim 1, having a complementary pair of suppression circuits arranged to use a signal from the second of the resistive inputs to generate a second corrective signal to suppress a common mode component in a signal from the first of the resistive inputs, and having circuitry to output the two suppressed signals as a differential signal.

3. The common mode suppression circuit of claim 2 whereby the output of the first of the complementary pair corresponds with the first component (V1A) of the differential signal and the output of the second of the complementary pair corresponds with the second component (V1B) of the differential signal.

4. A receiver for receiving a differential signal (V1A, V1B) and having a common mode suppression circuit according to any preceding claim.

5. The receiver according to claim 4 having a converter for converting the differential signal to a single ended signal.

6. The receiver of claim 5, the converter having resistive feedback to provide hysteresis.

7. The receiver of any or the claims 4 to 6 arranged for receiving LVDS type signals.

8. The suppression circuit of any of the claims 1 to 3 or the receiver of any or the claims 4 to 7, in the form of an integrated circuit.

**Patentansprüche**

1. Gleichtaktunterdrückungsschaltung mit Widerstandseingangen zum Empfangen eines Differenzialsignals und mit einem Korrektursignal-Erzeugungsschaltkreis, der zur Verwendung eines Signals von einem ersten der Widerstandseingänge ausgebildet ist, um ein Korrektursignal zu erzeugen, um eine Gleichtaktkomponente in dem Signal von dem zweiten der Widerstandseingänge zu unterdrücken,

wobei der Korrektursignal-Erzeugungsschaltkreis eine Stromspiegelschaltung mit zwei Transistoren (M1, M2) umfasst,

wobei der erste Widerstandseingang des Differenzia-signals (V1A) über einen ersten Widerstand (R1) mit einer Hauptstromelektrode des ersten (M1) der zwei Transistoren gekoppelt ist, und der zweite Widerstandseingang des Differenzialsignals (V1B) über einen zweiten Widerstand (R2) mit einer Hauptstromelektrode des zweiten Transistors (M2) gekoppelt ist,

wobei das Gate und die Hauptstromelektrode des ersten Transistors (M1) miteinander und mit dem Gate des zweiten Transistors (M2) verbunden sind, und wobei der Knoten (D) zwischen dem zweiten Widerstand (R2) und der Hauptstromelektrode des zweiten Transistors (M2) den Ausgang der Gleichtaktuterdrückungsschaltung bildet,

**dadurch gekennzeichnet, dass**

die Gleichtaktunterdrüakungsschaltung des Weiteren eine zweiten Stromspiegelschaltung umfasst, die parallel mit der ersten verbunden ist, wobei die Transistoren (M3, M4) in der zweiten Stromspiegelschaltung vom komplementären Typ der Transistoren (M1, M2) in der ersten Stromspiegelschaltung sind, und

wobei Eigenschaften der Transistoren und die Werte der Widerstände so ausgebildet sind, dass ein Korrektursignal mit einer Amplitude und einer Zeitsteuerung bereitgestellt wird, die zur Unterdrückung der Gleichtaktkomponente angemessen sind.

**2.** Gleichtaktuntererückungsschaltung nach Anspruch 1, mit einem komplementären Paar von Unterdrückungsschaltungen, die zur Verwendung eines Signals von dem zweiten der Widerstandseingänge ausgebildet sind, um ein zweites Korrektursignal zu erzeugen, um eine Gleichtaktkomponente in einem Signal von dem ersten der Widerstandseingänge zu unterdrücken, und mit einem Schaltkreis zur Ausgabe der zwei unterdrückten Signale als Differenzialsignal.

**3.** Gleichtaktunterdrückungsschaltung nach Anspruch 2, wobei der Ausgang des ersten des komplementären Paares mit der ersten Komponente (V1A) des Differenzialsignals übereinstimmt und der Ausgang des zweiten des komplementären Paares mit der zweiten Komponente (V1B) des Differenzialsignals übereinstimmt.

**4.** Empfänger zum Empfangen eines Differenzialsignals (V1A, V1B) und mit einer Gleichtaktunterdrückungsschaltung nach einem der vorangehenden Ansprüche.

**5.** Empfänger nach Anspruch 4, mit einem Wandler zum Umwandeln des Differenzialsignals in ein einpoliges ("single-ended") Signal.

**6.** Empfänger nach Anspruch 5, wobei der Wandler eine Widerstandsrückkopplung zur Bereitstellung einer Hysterese aufweist.

**7.** Empfänger nach einem der Ansprüche 4 bis 6, der zum Empfangen von Signalen vom LVDS-Typ ausgebildet ist.

**8.** Unterdrückungsschaltung nach einem der Ansprüche 1 bis 3 oder Empfänger nach einem der Ansprüche 4 bis 7 in der Form einer integrierten Schaltung.

**Revendications**

**1.** Circuit de suppression de mode commun, ayant des entrées résistives pour recevoir un signal différentiel, et ayant des circuits de production de signal correctif agencés pour utiliser un signal provenant d'une première des entrées résistives pour produire un signal correctif pour supprimer une composante de mode commun dans le signal provenant de la seconde des entrées résistives,
de sorte que les circuits de production de signal correctif comprennent un circuit de miroir de courant ayant deux transistors (M1, M2),
la première entrée résistive du signal différentiel (V1A) est couplée sur une première résistance (R1) à une électrode d'alimentation principale du premier (M1) des deux transistors et la seconde entrée résistive du signal différentiel (V1E) est couplée sur une seconde résistance (R2) à une électrode d'alimentation principale du second transistor (M2),
de sorte que la grille et ladite électrode d'alimentation principale du premier transistor (M1) sont reliées l'une à l'autre et à la grille du second transistor (M2), et de sorte que le noeud (D) entre la seconde résistance (R2) et ladite électrode d'alimentation principale du second transistor (M2) constitue La sortie du circuit de suppression de mode commun,
**caractérisé en ce que**
le circuit de suppression de mode commun comprend en outre un second circuit de miroir de courant, relié en parallèle au premier circuit, les transistors (M3, M4) dans le second circuit de miroir de courant étant du type complémentaire des transistors (M1, M2) dans le premier circuit de miroir de courant, et
dans lequel des caractéristiques des transistors et les valeurs des résistances sont agencées pour fournir un signal correctif avec une amplitude et une synchronisation conçues pour supprimer ladite composante de mode commun.

**2.** Circuit de suppression de mode commun selon la revendication 1, ayant un couple complémentaire de circuits de suppression agencés pour utiliser un signal provenant de la seconde des entrées résistives pour produire un second signal correctif pour supprimer une composante de mode commun dans un signal provenant de la première des entrées résistives, et ayant des circuits pour sortir les deux signaux supprimés en tant que signal différentiel.

**3.** Circuit de suppression de mode commun selon la revendication 2, de sorte que la sortie du premier du couple complémentaire correspond à la première composante (V1A) du signal différentiel et la sortie du second du couple complémentaire correspond à la seconde composante (V1B) du signal différentiel.

**4.** Récepteur pour recevoir un signal différentiel (V1A, V1B) et ayant un circuit de suppression de mode commun selon l'une quelconque des revendications précédentes.

5. Récepteur selon la revendication 4, ayant un convertisseur pour transformer le signal différentiel en un signal asymétrique.

6. Récepteur selon la revendication 5, le convertisseur ayant une rétroaction résistive pour fournir une hystérésis.

7. Récepteur selon l'une quelconque des revendications 4 à 6, agencé pour recevoir des signaux de type SDBT (signalisation différentielle à basse tension).

8. Circuit de suppression selon l'une quelconque des revendications 1 à 3 ou récepteur selon l'une quelconque des revendications 4 à 7, sous la forme d'un circuit intégré.

## FIG 1

DIFFERENTIAL
SIGNAL

→ | COMMON-MODE SUPPRESSION 10 | → | DIFFERENTIAL TO SINGLE-ENDED CONVERTER 20 | | AMPLIFIER WITH HYSTERESIS 30 | | OUTPUT STAGE 40 | →

## FIG 2

FIRST PATH RECEIVED CURRENT (COMMON MODE)

SECOND PATH RECEIVED CURRENT (DIFF. AND COMMON MODE)

| CORRECTIVE CURRENT GENERATOR 60 | → (COMMON MODE)

+

−

COMMON MODE SUPPRESSED OUTPUT

$V_{IA}$    $V_{IB}$

R1    R2

Ⓒ    Ⓓ

M1    M2

FIG 3

FIG 4

FIG 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6288576 B
- US 6654462 B
- EP 486071 A
- EP 1286143 A
- US 2002163381 A

**Non-patent literature cited in the description**

- **A. BONI ; A. PIERAZZI ; D. VECCHI.** LVDS I/O Interface for Gb/s-per-Pin Operation in 0.35-$\mu$m CMOS. *IEEE J.Solid-State Circuits,* vol. 36 (4), 706-711
- **M. AGUIRRE ; C. HEREDIA ; H. TORRES ; R. PALOMERA ; M. JIMÉNEZ.** Design of a CMOS 1.8V Low Voltage Differential Signaling Receiver. *Proc. Of the 45th IEEE Midwest Symposium on Circuits and Systems (MWCAS 2002,* August 2002, vol. 2, 647-649